(19) Europäisches Patentamt

European Patent Office

Office européen des brevets

(11) EP 0 509 285 B1

(12) **EUROPÄISCHE PATENTSCHRIFT**

(45) Veröffentlichungstag und Bekanntmachung des Hinweises auf die Patenterteilung:
**28.02.1996 Patentblatt 1996/09**

(51) Int Cl.6: **H03F 1/30**

(21) Anmeldenummer: **92105189.2**

(22) Anmeldetag: **26.03.1992**

(54) **Schaltungsanordnung zur Kompensation von Temperatureinflüssen in einem Halbleiter-Verstärker**

Temperature compensating circuit for a semi-conductor amplifier

Circuit de compensation de température pour un amplificateur à semi-conducteur

(84) Benannte Vertragsstaaten:
**DE FR GB IT**

(30) Priorität: **18.04.1991 DE 4112697**

(43) Veröffentlichungstag der Anmeldung:
**21.10.1992 Patentblatt 1992/43**

(73) Patentinhaber:
**GRUNDIG E.M.V. Elektro-Mechanische Versuchsanstalt Max Grundig GmbH & Co. KG D-90762 Fürth (DE)**

(72) Erfinder:
- **Dreyer, Jürgen, Dipl.-Ing., GRUNDIG E.M.V. W-8510 Fuerth (DE)**
- **Zergiebel, Volker, Dipl.-Ing., GRUNDIG E.M.V. W-8510 Fuerth (DE)**

(56) Entgegenhaltungen:
**US-A- 3 452 281          US-A- 3 588 550**

**Beschreibung**

Die Erfindung betrifft eine Schaltungsanordnung zur Kompensation einer temperaturabhängigen Verstärkungsänderung eines Halbleiter-Verstärkers, insbesondere eines ZF-Verstärkers in einem Autoradio. Sie setzt dabei voraus, daß die Verstärkung des betroffenen Verstärkers mit Hilfe einer Gleichspannung in bestimmten Grenzen steuerbar ist.

Ein Verfahren und eine Anordnung dieser Art ist aus der EP-A-0289807 bekannt. Die darin beschriebene Schaltung setzt sich aus einem Temperaturfühler, einem Multiplizierer, der eine Steuergröße zur Einstellung der Verstärkung mit einer temperaturproportionalen Größe verknüpft, einem Addierer und einem zwischen zwei Verstärkerstufen eingefügten Stellglied zusammen.

Aus der DE-A1-31 06 703 ist eine Schaltung zur Temperaturkompensation bekannt, die zur Integration in einer Halbleiterschaltung vorgesehen ist und die sich zweier temperaturabängiger Widerstände mit unterschiedlichen Temperaturkoeffizienten bedient. Zur Erzielung des unterschiedlichen Temperaturverhaltens wird einer der beiden Widerstände in Diffusionstechnik, der andere in Dickschichttechnik hergestellt, wobei die Widerstandswerte so gewählt werden, daß ein weitgehend temperaturunabhängiges Verhalten der Halbleiterschaltung erreicht wird.

Zur individuellen Temperaturkompensation eines beliebigen, von außen steuerbaren Verstärkers, der auch in sich geschlossen als integrierte Schaltung aufgebaut sein kann, ist die vorbeschriebene Schaltung nicht geeignet, da sie auf eine bestimmte Halbleiteranordnung abgestimmt und durch die Integration auf dem Halbleiterchip in ihrem Temperaturverhalten fixiert ist.

Eine Wahlmöglichkeit für den Einsatzpunkt der temperaturabhängigen Steuerung ist nicht vorgesehen. Außerdem erfordert die Schaltung einen verhältnismäßig hohen technischen Aufwand.

Nach dem Stand der Technik ist es auch bekannt, temperaturabhängige Verstärkungsänderungen in aktiven Netzwerken mit Hilfe von temperaturabhängigen Widerständen (NTC/PTC) zu kompensieren. Solche Bauteile sind jedoch gegenüber den in der vorliegenden Erfindung verwendeten Bauelementen verhältnismäßig teuer, vor allem, wenn ein definiertes Temperaturverhalten gefordert wird.

Weiterhin ist aus der US-A-3 452 281 ein Transistorverstärker bekannt, bei dem die Temperaturkompensation mit Hilfe einer Diode ohne Verschlechterung der Eingangsimpedanz vprge,pùue, word. Zur Lösung dieser technische Aufgabe wird beim NF-Verstärker gemäß US-A-3 452 281 das Spannungsteilerverhältnis der Widerstände 26 und 27 in Hinblick auf die Eingangsimpedanz des NF-Verstärkers gewählt und die optimale Temperaturkompensation wird mittels der Diode 24 und des Widerstands 28 durchgeführt wird. Weiterhin ist als Lastwiderstand ein Widerstand 16 vorgesehen und mittels eines Widerstands 19 wird eine Gegenkopplung des Verstärkertransistors 11 realisiert.

Schließlich ist aus der US-A-3 588 550 eine Stromspiegelschaltung bekannt, bei der eine Temperaturkompensation durch Angleichung der Basis-Emitter-Spannungen vorgenommen wird.

Es war deshalb Aufgabe der Erfindung, eine kostengünstige Kompensationsschaltung zu schaffen, deren Ausgangsspannung sich ab einem bestimmten Temperatur-Schwellwert linear in Abhängigkeit der Temperatur ändert, wobei der Einsatzpunkt und der Proportionalitätsfaktor frei wählbar sein sollten. Außerdem sollte kein getrennter Temperaturfühler erforderlich sein, sondern der Temperaturduchgriff der in der Schaltung verwendeten Transistoren zur Auswertung der Temperatur herangezogen werden.

Diese Aufgabe wird durch eine Temperaturkompensationsschaltung entsprechend der in den Ansprüchen 1 und 2 genannten Merkmale gelöst. Ausgestaltungen der Erfindung sind Bestandteil der Unteransprüche.

Anhand der Zeichnungen wird die Erfindung nachfolgend näher erläutert. Es zeigen:

Fig. 1 eine Kompensationsschaltung mit proportional zur Temperatur ansteigender Steuerspannung;

Fig. 2 eine Kompensationsschaltung mit proportional zur Temperatur abfallender Steuerspannung;

Fig. 3 ein Anwendungsbeispiel für eine Temperaturkompensation in einem Autoradio.

Fig. 4 Verlauf der Feldstärkegleichspannung in Abhängigkeit der Umgebungstemperatur mit und ohne Temperaturkompensation.

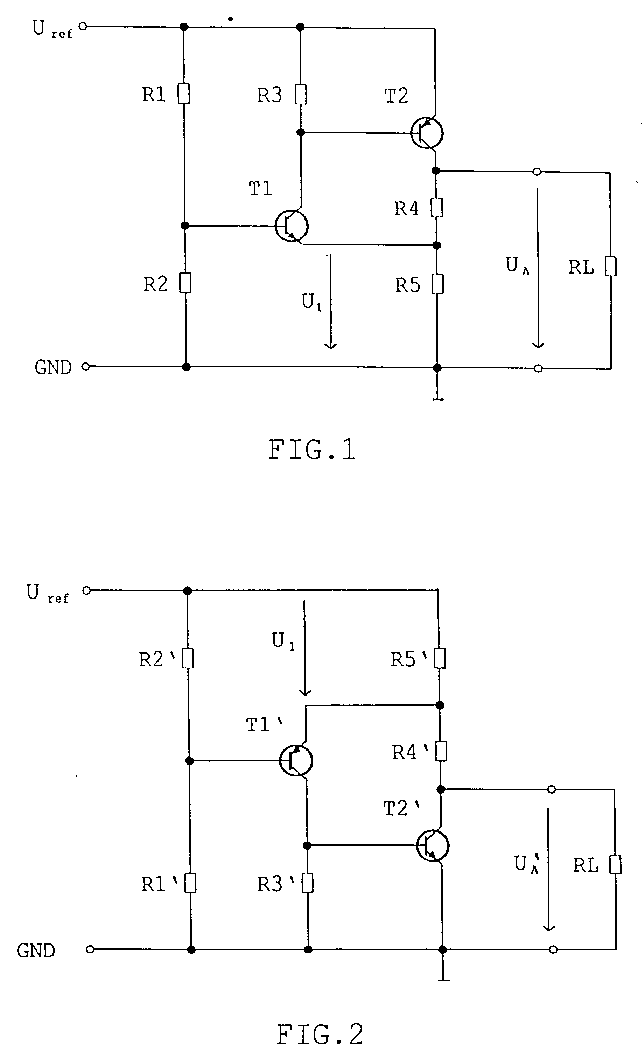

Die Kompensationsschaltung nach Fig. 1 ist in Form eines zweistufigen Gleichspannungsverstärkers mit Transistoren unterschiedlicher Leitfähigkeit aufgebaut. Die Basis des NPN-Transistors T1 ist über den Spannungsteiler R1, R2, der zwischen der stabilisierten Referenzspannung $U_{ref}$ und der Masse GND liegt, auf ein festes Potential gegenüber Masse bezogen. Der Emitter des Transistors T1 liegt über den Widerstand R5 ebenfalls an Masse. Über den Arbeitswiderstand R3 ist der Kollektor des Transistors T1 mit der Referenzspannung $U_{ref}$ verbunden, außerdem besteht eine galvanische Verbindung zur Basis des PNP-Transistors T2. Da der Emitter des Transistors T2 potentialgleich mit der Referenzspannung ist, erfolgt die Ansteuerung des Transistors T2 über den Spannungsabfall an dem Widerstand R3. Der Kollektor des Transistors T2 ist in Form einer Stromgegenkopplung über den Widerstand R4 mit dem Emitter des Transistors T1 verbunden. Die Verstärkung v der Doppelstufe berechnet sich deshalb zu:

$$v = 1 + \frac{R4}{R5} \qquad (1)$$

Unter der Voraussetzung, daß die Steuerspannung $U_A$ zwischem dem Kollektor des Transistors T2 und Masse abgegriffen wird und daß der Lastwiderstand RL sehr hochohmig ist, ergibt sich für den absoluten Wert der Steuerspannung $U_A$:

$$\left| U_A = \left( 1 + \frac{R4}{R5} \right) \cdot U_1 \right| \qquad (2)$$

wobei $U_1$ der am Emitterwiderstand R5 verursachte Spannungsabfall ist.

Die Basis-Emitter-Strecken der Transistoren T1 und T2 unterliegen dem Temperaturdurchgriff d, der zur Veränderung der Steuerspannung $U_A$ ausgenutzt werden soll. Da der Temperaturkoeffizient des Transistors T2 nur unbedeutende Auswirkung auf die Steuerspannung $U_A$ hat, konzentriert sich die Betrachtung auf den Temperaturdurchgriff des Transistors T1. Dieser kann näherungsweise angegeben werden mit:

$$d \approx \frac{2mV}{K} \qquad (3)$$

Da die Basis des Transistors T1 über den Spannungsteiler R1, R2 an einem festen Spannungspotential liegt, ändert sich die Spannung $U_1$ um einen Betrag $\Delta U_1$, der aus dem Produkt der Temperaturdrift $\Delta\vartheta$ und dem Temperaturdurchgriff d gebildet wird.

Unter Berücksichtigung der Gleichungen (2) und (3) ergibt sich eine temperaturabhängige Änderung der Steuerspannung $U_A$ von:

$$\Delta^U{}_a \approx \left( 1 + \frac{R4}{R5} \right) \cdot \frac{2mV}{K} \cdot \Delta\vartheta \qquad (4)$$

Mit Hilfe des Spannungsteilers R1, R2 kann das Basispotential des Transistors T1 so gewählt werden, daß sich bei einer bestimmten Temperatur $\vartheta_o$ (z.B. Zimmertemperatur) die Ausgangsspannung $U_{a\vartheta_o}$ ergibt. Die Steuerspannung $U_A$ setzt sich dann zusammen aus

$$U_A = U_{a\vartheta_o} + \Delta U_a \qquad (5)$$

wobei sich die Spannungsänderung $\Delta U_a$ auf die Einstelltemperatur $\vartheta_o$ bezieht.

Da entsprechend Gleichung (2)

$$U_{a\vartheta_o} = \left( 1 + \frac{R4}{R5} \right) \cdot U_{1\vartheta_o} \qquad (6)$$

ist, kann die Steuerspannung $U_A$ durch Verknüpfen der Gleichungen (4), (5) und (6) berechnet werden zu:

$$U_A \approx \left( 1 + \frac{R4}{R5} \right) \cdot \left( \frac{2mV}{K} \cdot \Delta\vartheta + U_{1\vartheta_o} \right) \qquad (7)$$

Bei negativem $\Delta\vartheta$, d.h. bei Abkühlung, kann die Steuerspannung $U_A$ allerdings nur solange abnehmen, bis

$$\left| d \cdot \Delta\vartheta \right| = \left| U_{1\vartheta_o} \right|$$

ist, d.h., bis die Schwellwerttemperatur $\vartheta_s$ erreicht wird, bei welcher der Transistor T1 sperrt. Unterhalb dieser Schwelle gilt für die Steuerspannung: $U_A = 0\ V$.

Da durch Wahl der Widerstände R1 und R2 die Schwellwerttemperatur $\vartheta_s$, bei der die temperaturabhängige Steuerspannung $U_A$ einsetzt, frei wählbar ist und über das Verhältnis der Widerstände R4 und R5 der Proportionalitätsfaktor für die Temperaturabhängigkeit der Steuerspannung $U_A$ beliebig vorgegeben werden kann, ist es möglich, die Kompensationsschaltung an Verstärker mit verschiedenartigem Temperaturverhalten anzupassen.

Die Referenzspannung $U_{ref}$ sollte zwar trotz lastabhängiger Amplitudenschwankung einer nicht dargestellten unstabilisierten Versorgungsspannung spannungsstabil sein, kann aber eine eigene Temperaturdrift aufweisen. Durch die flexible Anpassungsfähigkeit der Schaltung kann ein möglicher Temperaturgang der Referenzspannung durch entsprechende Schaltungsdimensionierung zusätzlich kompensiert werden.

In der gleichen vorbeschriebenen Weise läßt sich auch das Temperaturverhalten der in Fig. 2 dargestellten Schaltung herleiten. Im Gegensatz zur Schaltung in Fig. 1 fällt jedoch die Steuerspannung $U_A$ bei steigender Temperatur ab. Mit den Widerständen R1' und R2' kann ebenfalls die Schwellwerttemperatur $\vartheta_s$ für das Einsetzen der temperaturproportionalen Steuerspannung $U_A'$ bzw. eine bestimmte Ausgangsspannung $U_{a\vartheta_o}$ bei einer Einstelltemperatur $\vartheta_o$ frei gewählt werden.

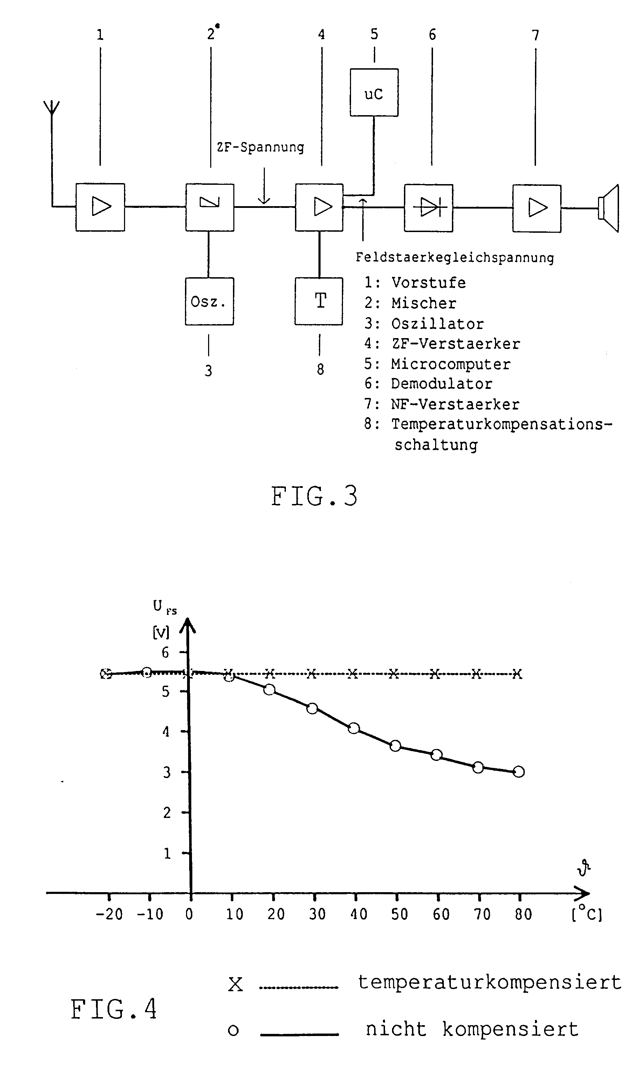

Fig. 3 zeigt als Anwendungsbeispiel ein Autoradio, bei dem die in Fig. 1 dargestellte Schaltung zur Kompensation der temperaturabhängigen Verstärkungsänderung des ZF-Verstärkers verwendet wird. Wegen des weiten Temperaturbereiches von -20°C bis +80°C, innerhalb dessen im Fahrzeug eingebaute Geräte voll funktionsfähig sein müssen, bestehen besonders hohe Anforderungen an die Temperaturunbhängigkeit der signalverarbeitenden Schaltungsgruppen.

Das Autoradio nach Fig. 3 setzt sich in bekannter Weise aus einer Vorstufe 1, einem Mischer 2 mit einem Überlagerungsoszillator 3, einem ZF-Verstärker 4, einem Demodulator 6 und einem NF-Verstärker 7 zusammen. Der Mikrocomputer 5 übernimmt neben verschiedenen Funktionen der Gerätesteuerung auch die automatische Senderabstimmung durch entsprechende Steuersignale an den durchstimmbaren Überlagerungsoszillator 3. U.a. überwacht der Mikrocomputer 5 die Feldstärke des aktuell empfangenen Senders, indem er ein vom ZF-Verstärker nach Maßgabe der Feldstärke erzeugtes Gleichspannungssignal auswertet. Unterschreitet die Feldstärke des aktuell empfangenen Senders einen vorgebbaren Mindestwert, so leitet der Mikrocomputer 5 beispielsweise einen automatischen Suchlauf nach einem Sender mit besserer Empfangsqualität ein.

Der Wert der Feldstärkegleichspannung $U_{FS}$ hängt jedoch vom Verstärkungsgrad des ZF-Verstärkers ab. Ist dessen Verstärkung temperaturabhängig, so kann je nach Umgebungstemperatur eine Verschlechterung der Empfangsverhältnisse vorgetäuscht werden, obwohl sich die Senderfeldstärke nicht geändert hat. Fig. 4 zeigt mit der ausgezogenen Linie exemplarisch den nicht kompensierten Verlauf der Feldstärkegleichspannung $U_{FS}$ in Abhängigkeit der Umgebungstemperatur $\vartheta$ eines im Anwendungsbeispiel nach Fig. 3 verwendeten ZF-Verstärkers, der zusammen mit anderen Schaltungsgruppen in einem IC integriert ist. Dieser IC besitzt einen Steuereingang, über den mit Hilfe einer Gleichspannung die ZF-Verstärkung eingestellt werden kann. An diesen Eingang ist nun die erfindungsgemäße Temperaturkompensationsschaltung 8 angeschlossen, die derselben Umgebungstemperatur wie der ZF-Verstärker ausgesetzt ist. Wie aus Fig. 4 anhand der gestrichelten Kurve ersichtlich, kann mit Hilfe der Kompensationsschaltung die ZF-Verstärkung und damit auch die dem Mikrocomputer 5 zugeführte Feldstärkegleichspannung $U_{FS}$ über einen weiten Temperaturbereich konstant gehalten werden.

Die Verwendung der Kompensationsschaltung ist natürlich nicht allein an die Verwendung in Verstärkerschaltungen gebunden, sondern kann in allen Fällen eingesetzt werden, in denen mit Hilfe einer Gleichspannung der monoton verlaufende Temperaturgang einer Schaltung kompensiert werden kann.

## Patentansprüche

1. Temperaturkompensationsschaltung (8) für einen Halbleiter-Verstärker (4), wobei die Temperaturkompensationsschaltung (8) derselben Umgebungstemperatur wie der Halbleiter-Verstärker (4) ausgesetzt ist und wobei dessen Verstärkung mit Hilfe einer Gleichspannung steuerbar ist,
**dadurch gekennzeichnet**, daß die Temperaturkompensationsschaltung (8) in Form eines zweistufigen Gleichspannungsverstärkers mit Transistoren (T1, T2) unterschiedlicher Leittähigkeit aufgebaut ist, welche derart verschaltet sing, daß

a) die Basis eines NPN-Transistors (T1) am Mittenabgriff eines ersten Spannungsteilers (R1, R2) zwischen einer Referenzspannung ($U_{ref}$) und Masse (GND) angeschlossen ist, wobei durch die Wahl des Spannungsteilerverhältnisses R2/(R1+R2) eine Temperaturschwelle ($\vartheta_s$) einstellbar ist, ab der eine temperaturabhängige Steuerspannung ($U_A$) für den Halbleiter-Verstäker (4) eizeugt wird.
b) der Kollektor des NPN-Transistors (T1) mit der Basis eines PNP-Transistors (T2) galvanisch verbunden ist und über einen Widerstand (R3) ebenso wie der Emitter des PNP-Transistors (T2) von der Referenzspannung ($U_{ref}$) versorgt wird, wobei die Ansteuerung des PNP-Transistors (T2) über den Spannungsabfall an dem Widerstand (R3) erfolgt,
c) der Emitter des NPN-Transistors (T1) auf den Mittenabgriff eines zweiten Spannungsteilers (R4, R5) geführt ist, der die Verbindung zwischen dem Kollektor des PNP-Transistors (T2) und Masse (GND) bildet, wobei durch den invertierten Wert des Spannungsteilerverhältnisses R5/(R4+R5) der Proportionalitätsfaktor für die temperaturabhängige Steuerspannung ($U_A$) vorgebbar ist,

und daß die mit der Temperatur monoton steigende Steuerspannung ($U_A$) zwischen dem Kollektor des PNP-Transistors (T2) und der Masse (GND) abgenommen wird.

2. Temperaturkompensationsschaltung nach dem Oberbegriff des Anspruchs 1. **dadurch gekennzeichnet**, die Temperaturkompensationsschaltung (8) in Form eines zweistufigen Gleichspannungsverstärkers mit Transistoren (T1, T2) unterschiedlicher Leitfähigkeit aufgebaut ist, welche derart verschaltet sind, daß

a) die Basis eines PNP-Transistors (T1') am Mittenabgriff eines ersten Spannungsteilers (R1', R2') zwischen einer Referenzspannung ($U_{ref}$) und Masse (GND) angeschlossen ist, wobei durch die Wahl des Spannungsteilerverhältnisses R2'/(R1'+R2') eine Temperaturschwelle ($\vartheta_s$) einstellbar ist, ab der eine temperaturabhängige Steuerspannung ($U_A$') für den Halbleiter-Verstärker (4) erzeugt wird,
b) der Kollektor des PNP-Transistors (T1') mit der Basis des NPN-Transistors (T2') galvanisch verbunden ist und über den Widerstand (R3') ebenso wie der Emitter des NPN-Transistors (T2') auf Masse (GND) liegt, wobei die Ansteuerung des PNP-Transistors (T2') über den Spannungsabfall an dem Widerstand (R3') erfolgt,
c) der Emitter des PNP-Transistors (T1`) auf den Mittenabgriff eines zweiten Spannungsteilers (R4',R5') geführt ist, der die Verbindung zwischen dem Anschluß der Referenzspannung ($U_{ref}$) und dem Kollktor des NPN-Transistors (T2') bildet, wobei durch den invertierten Wert des Spannungsteilerverhältnisses R5'/(R4'+R5') der Proportionalitätsfaktor für die temperaturabhängige Steuerspannung ($U_A$') vorgebbar ist,

und daß die mit der Temperatur monoton fallende Steuerspannung ($U_A$') zwischen dem Kollektor des NPN-Transistors (T2') und der Masse (GND) abgenommen wird.

3. Temperaturkompensationsschaltung nach Anspruch 1 oder 2, **dadurch gekennzeichnet**, daß der Temperaturdurchgriff (d) des NPN-Transistors (T1) bzw. des PNP-Transistors (T1') zur Erzeugung der temperaturabhängigen Steuerspannung ($U_A$ bzw. $U_A$') herangezogen wird.

4. Schaltungsanordnung nach einem der vorhergehenden Ansprüche, **dadurch gekennzeichnet**, daß durch die Wahl der Temperaturschwelle ($\vartheta_s$)

und des Proportionalitätsfaktors für die temperaturabhängige Steuerspannung (U$_A$ bzw. U$_{A'}$) ein Temperaturdrift der Referenzspannung (U$_{ref}$) zusätzlich kompensiert wird.

## Claims

1. Temperature-compensating circuit (8) for a semiconductor amplifier (4), the temperature-compensating circuit (8) being exposed to the same ambient temperature as the semiconductor amplifier (4) and its gain being controllable with the aid of a direct voltage, characterized in that the temperature-compensating circuit (8) is constructed in the form of a two-stage direct-voltage amplifier containing transistors (T1, T2) which have different conductivity and which are connected in such a way that

   a) the base of an N-P-N transistor (T1) is connected to the centre tap of a first voltage divider (R1, R2) between a reference voltage (U$_{ref}$) and earth (GND), a temperature threshold ($\theta_s$) at and above which a temperature-dependent control voltage (U$_A$) is generated for the semiconductor amplifier (4) being settable by the choice of the voltage divider ratio R2/(R1+R2),
   b) the collector of the N-P-N transistor (T1) is conductively connected to the base of a P-N-P transistor (T2) and, like the emitter of the P-N-P transistor (T2), is supplied by the reference voltage (U$_{ref}$) via a resistor (R3), the P-N-P transistor (T2) being driven by means of the voltage drop across the resistor (R3),
   c) the emitter of the N-P-N transistor (T1) is connected to the centre tap of a second voltage divider (R4, R5) which forms the connection between the collector of the P-N-P transistor (T2) and earth (GND), the proportionality factor for the temperature-dependent control voltage (U$_A$) being settable by means of the inverted value of the voltage divider ratio R5/(R4 + R5),

   and in that the control voltage (U$_A$) which rises monotonically with temperature is taken off between the collector of the P-N-P transistor (T2) and earth (GND).

2. Temperature-compensating circuit according to the preamble of Claim 1, characterized in that the temperature-compensating circuit (8) is constructed in the form of a two-stage direct-voltage amplifier containing transistors (T1, T2) which have different conductivity and which are connected in such a way that

   a) the base of a P-N-P transistor (T1') is connected to the centre tap of a first voltage divider (R1', R2') between a reference voltage (U$_{ref}$) and earth (GND), a temperature threshold ($\theta_s$) at and above which a temperature-dependent control voltage (U$_A'$) is generated for the semiconductor amplifier (4) being settable by the choice of the voltage divider ratio R2'/(R1'+R2'),
   b) the collector of the P-N-P transistor (T1') is conductively connected to the base of the N-P-N transistor (T2') and, like the emitter of the N-P-N transistor (T2'), is connected to earth (GND) via the resistor (R3'), the P-N-P transistor (T2') being driven by means of the voltage drop across the resistor (R3'),
   c) the emitter of the P-N-P transistor (T1') is connected to the centre tap of a second voltage divider (R4', R5') which forms the connection between the terminal of the reference voltage (U$_{ref}$) and the collector of the N-P-N transistor (T2'), the proportionality factor for the temperature-dependent control voltage (U$_A'$) being settable by means of the inverted value of the voltage divider ratio R5'/(R4' + R5'),

   and in that the control voltage (U$_A'$), which falls monotonically with temperature, is taken off between the collector of the N-P-N transistor (T2') and earth (GND).

3. Temperature-compensating circuit according to Claim 1 or 2, characterized in that the temperature sensitivity (d) of the N-P-N transistor (T1) or of the P-N-P transistor (T1') is used to generate the temperature-dependent control voltage (U$_A$ or U$_A'$).

4. Circuit arrangement according to one of the preceding claims, characterized in that any temperature drift of the reference voltage (U$_{ref}$) is additionally compensated for by the choice of the temperature threshold ($\theta_S$) and of the proportionality factor for the temperature-dependent control voltage (U$_A$ or U$_A'$).

## Revendications

1. Circuit de compensation de température (8) pour un amplificateur à semiconducteurs (4), le circuit de compensation te température (8) étant soumis à la même température ambiante que l'amplificateur à semiconducteurs (4) et l'amplification de ce dernier pouvant être commandée à l'aide d'une tension continue,
   caractérisé en ce que le circuit de compensation de température (8) est agencé sous la forme d'un amplificateur de tension continue à deux étages comportant les transistors (T1,T2) ayant des conductivités différentes et qui sont interconnectés de telle sorte que

   a) la base d'un transistor NPN (TI) est raccordée

à la prise médiane d'un premier diviseur de tension (R1,R2) entre une tension de référence ($U_{ref}$) et la masse (GND), un seuil de température ($\vartheta_s$), à partir duquel est produite une tension de commande ($U_A$), qui dépend de la température, pour l'amplificateur à semiconducteurs (4), étant réglable grâce au choix du rapport de division de tension R2/(R1+R2),

b) le collecteur du transistor NPN (T1) est relié galvaniquement à la base d'un transistor PNP (T2) et est alimenté, par l'intermédiaire d'une résistance (R3), de même que l'émetteur du transistor PNP (T2), par la tension de référence ($U_{ref}$), la commande du transistor PNP (T2) étant réalisée au moyen de la chute de tension aux bornes de la résistance (R3),

c) l'émetteur du transistor NPN (T1) est raccordé à la prise médiane d'un second diviseur de tension (R4,R5), qui forme la liaison entre le collecteur du transistor PNP (T2) et la masse (GND), le facteur de proportionnalité pour la tension de commande ($U_A$), qui dépend de la température, pouvant être prédéterminé par la valeur inversée du rapport de division de tension R5/(R4+R5), et

que la tension de commande ($U_A$), qui augmente d'une manière monotone avec la température, est prélevée entre le collecteur du transistor PNP (T2) et la masse (GND).

2. Circuit de compensation de température selon le préambule de la revendication 1, caractérisé en ce que le circuit de compensation de température (8) est constitué sous la forme d'un amplificateur de tension continue à deux étages comportant des transistors (T1,T2) ayant des conductivités différentes et qui sont interconnectés de telle sorte que

a) la base d'un transistor NPN (T1') est raccordée à la prise médiane d'un premier diviseur de tension (R1',R2') entre une tension de référence ($U_{ref}$) et la masse (GND), un seuil de température ($\theta_S$), à partir duquel est produite une tension de commande ($U_A'$), qui dépend de la température, pour l'amplificateur à semiconducteurs (4), étant réglable grâce au choix du rapport de division de tension R2'/(R1'+R2'),

b) le collecteur du transistor PNP (T1') est relié galvaniquement à la base d'un transistor PNP (T2') et est raccordé, par l'intermédiaire de la résistance (R3'), de même que l'émetteur du transistor PNP (T2'), à la masse (GND), la commande du transistor PNP (T2') s'effectuant au moyen de la chute de tension aux bornes de la résistance (R3'),

c) l'émetteur du transistor PNP (T1') est raccordé à la prise médiane d'un second diviseur de tension (R4', R5'), qui forme la liaison entre la borne de la tension de référence ($U_{ref}$) et le collecteur du transistor NPN (T2'), le facteur de proportionnalité pour la tension de commande ($U_A'$), qui dépend de la température, pouvant être prédéterminé par l'inverse de la valeur du rapport de division de tension R5'/(R4'+R5'), et

que la tension de commande ($U_A'$), qui diminue de façon monotone avec la température, est prélevée entre le collecteur du transistor PNP (T2') et la masse (GND).

3. Circuit de compensation de température selon la revendication 1 ou 2, caractérisé en ce qu'on utilise le rapport inverse de température (d) du transistor NPN (T1) ou du transistor PNP (T1') pour produire la tension de commande ($U_A$ ou $U_A'$) qui dépend de la température.

4. Circuit de compensation de température selon l'une des revendications précédentes, caractérisé en ce qu'une dérive, due à la température, de la tension de référence ($U_{ref}$) est compensée de façon supplémentaire grâce au choix du seuil de température ($\vartheta_s$) et du facteur de proportionnalité pour une tension de commande ($U_A$ ou $U_A'$), qui dépend de la température.

FIG.1

FIG.2

ZF-Spannung

uC

Feldstaerkegleichspannung

Osz.

T

1: Vorstufe
2: Mischer
3: Oszillator
4: ZF-Verstaerker
5: Microcomputer
6: Demodulator
7: NF-Verstaerker
8: Temperaturkompensationsschaltung

FIG.3

$U_{FS}$
[V]

6

5

4

3

2

1

-20 -10 0 10 20 30 40 50 60 70 80  [°C]

$\vartheta$

X ............ temperaturkompensiert

FIG.4

o ———— nicht kompensiert